Europäisches Patentamt

European Patent Office

Office européen des brevets

(11) Publication number: **0 499 645 A1**

# EUROPEAN PATENT APPLICATION
## published in accordance with Art. 158(3) EPC

(21) Application number: 91915986.3

(22) Date of filing: **12.09.91**

(86) International application number:
**PCT/JP91/01212**

(87) International publication number:
**WO 92/04770 (19.03.92 92/07)**

(51) Int. Cl.⁵: **H03F 3/45**

(30) Priority: **12.09.90 JP 241777/90**

(43) Date of publication of application:
**26.08.92 Bulletin 92/35**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**
Applicant: **FUJITSU VLSI LIMITED**
**1844-2, Kozoji-cho 2-chome**
**Kasugai-shi Aichi 487(JP)**

(72) Inventor: **YAMASHITA, Masahiro**
**Fujitsu VLSI Ltd., 1844-2, Kozojicho 2-chome**
**Kasugai-shi, Aichi 487(JP)**
Inventor: **NISHIMURA, Hirokazu**
**Fujitsu VLSI Ltd., 1844-2, Kozojicho 2-chome**
**Kasugai-shi, Aichi 487(JP)**

(74) Representative: **Gibbs, Christopher Stephen et al**
**Haseltine Lake & Co. Hazlitt House 28**
**Southampton Buildings**
**Chancery Lane, London WC2A 1AT(GB)**

(54) **DIFFERENTIAL AMPLIFYING CIRCUIT OF OPERATIONAL AMPLIFIER.**

(57) An operational amplifying circuit, the linearity of whose output voltage to the input voltage thereof can be ensured ranging from a first power supply to a second one. A differential circuit (1) comprising a first and a second FET transistor (T11, T12) having channels of a first conductive type, a current Miller circuit part (2) comprising a first and a second FET transistor (T13, T14) having channels of a second conductive type which are connected with the differential amplifying circuit (1) respectively, a constant current circuit part (3) which is connected to the differential amplifying circuit (1) on the second power supply (GND) side, and an output circuit part (4) comprising a third FET transistor (T7) of the second conductive type whose gate terminal is connected with the drain terminal of the second FET transistor (T12) and a constant current circuit. The potential (a) of the connecting part between the differential amplifying circuit part and the constant current circuit part (3) is set to zero volt or more when an input signal Vin is zero volt, and the potential difference between the potential (a) and the potential (b) of the gate of the third FET transistor is ensured in the whole range of the voltage change of the input signal Vin.

# Fig.1

TECHNICAL FIELD

This invention relates to a differential amplifier circuit used for an operational amplifier.

BACKGROUND ART

Operational amplifier circuits in recent years are required to have an expanded range of output voltage and guarantee a linearity of the output voltage in the range.

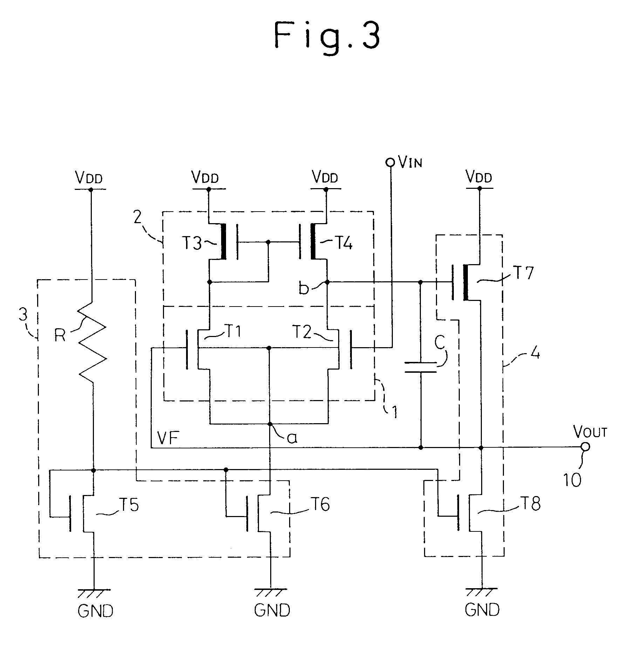

Figure 3 shows a voltage follower type output buffer, which is a conventional differential circuit used for an operational amplifier.

Source terminals of first and second NMOS transistors T1 and T2 are connected to each other to form a differential amplifier circuit portion 1. Drain terminals of the NMOS transistors T1 and T2 are connected to a power source VDD through first and second PMOS transistors T3 and T4. The first and second PMOS transistors T3 and T4 form a current mirror circuit portion 2. Gate terminals of the PMOS transistors T3 and T4 are connected to the drain terminal of the first NMOS transistor T1.

The source terminals of the first and second NMOS transistors T1 and T2 are connected to a low voltage source (ground) GND through a constant-current circuit portion 3, that comprises a resistor R and NMOS transistors T5 and T6. A gate terminal of the second NMOS transistor T2 receives an input voltage VIN. A gate terminal of the first NMOS transistor T1 is connected to an output terminal 10.

An output circuit portion 4 comprises a third PMOS transistor T7 and a constant-current circuit formed from the resistor R, the NMOS transistor T5, and an NMOS transistor T8. The third PMOS transistor T7 has a gate terminal connected to the drain terminal of the second NMOS transistor T2, and a drain terminal connected to the output terminal 10.

The first and second NMOS transistors T1 and T2 are enhancement type transistors. Back gates of the NMOS transistors T1 and T2 are connected to the source terminals of themselves.

A phase compensation capacitor C is disposed between the second PMOS transistor T4 and the output terminal 10.

When the input voltage VIN exceeds a potential (a feedback voltage VF) of the gate terminal of the NMOS transistor T1, the NMOS transistor T2 is turned ON to lower a drain potential b thereof. According to the drain potential b of the NMOS transistor T2, a gate-source potential of the PMOS transistor T7 of the output circuit portion 4 decreases below a threshold value, and therefore, the PMOS transistor T7 is turned ON. Accordingly, an output voltage VOUT of the output terminal 10 increases. The feedback voltage VF that increases according to the output voltage VOUT maintains an output voltage VOUT equal to the input voltage VIN.

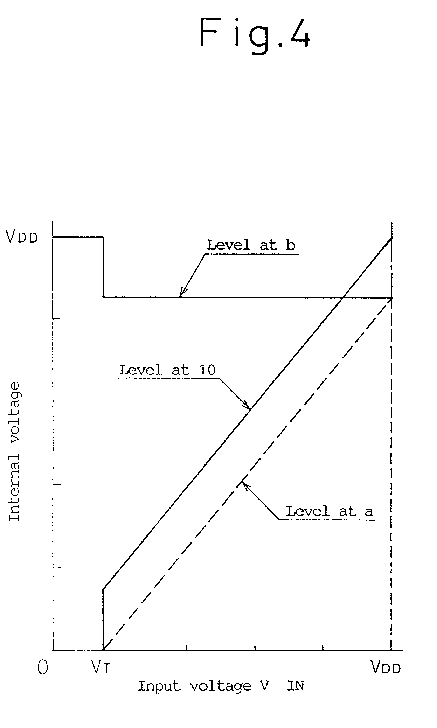

Since the first and second NMOS transistors T1 and T2 of this conventional operational amplifier circuit are enhancement type transistors, a threshold voltage VT thereof is usually 1 V or greater. When the input voltage VIN is lower than the threshold voltage VT, the first and second NMOS transistors T1 and T2 are turned OFF, so that the potential level of a node a is zeroed, and the potential level of the node b becomes substantially equal to the level of the power source VDD, as shown in Fig. 4. This causes the PMOS transistor T7 to turn OFF. Then, the output voltage VOUT is zeroed. This means that a normality of the output voltage VOUT is not guaranteed when the input voltage VIN is low.

On the other hand, when the input voltage VIN approaches VDD, a source-drain potential difference of the transistors T1 and T2 forming the differential amplifier circuit portion is nearly zeroed. As a result, the output VOUT does not follow the input VIN, i.e., the output VOUT and the input VIN do not match each other.

The conventional differential amplifier circuit mainly detects the voltage level of the input signal VIN alone, and in response to this, provides an output voltage. The operational amplifier circuit, however, must provide an output signal (VOUT) whose voltage level accurately follows the voltage level of an input signal for an entire range of changes that occur in the input signal. If the operational amplifier employs the conventional differential amplifier circuit mentioned above having a threshold range of, for example, from 0.8 V to 5.0 V, the operational amplifier will operate only within this range. This will limit the width of an output voltage with respect to an input voltage. To solve this problem, the conventional operational amplifier employs a level converter, etc. There is, therefore, a necessity of providing an operational amplifier that provides a correct output signal for an entire range of changes that may occur in an input voltage.

To meet this requirement, an object of the invention is to provide a differential amplifier circuit for an operational amplifier that guarantees a linearity of output voltage with respect to input voltage ranging from a first power source level to a second power source level.

DISCLOSURE OF THE INVENTION

To achieve the object, the invention provides the following technical configuration.

A differential amplifier circuit of an operational amplifier comprises a differential amplifier circuit portion (1) involving differentially connected first and second first-conduction-type FETs (T11, T12) for differentially amplifying an input voltage, a current mirror circuit portion (2) involving first and second second-conduction-type FETs (T13, T14) connected to the differential amplifier circuit portion (1) on the side of a first power source (VDD), a constant-current circuit portion (3) connected to the differential amplifier circuit portion (1) on the side of a second power source (GND), an output circuit portion (4) involving a third second-conduction-type FET (T7) having a gate terminal connected to a drain terminal of the second first-conduction-type FET (T12), and a constant-current circuit. A potential (a) at a node between the differential amplifier circuit portion and the constant-current circuit portion (3) is 0 V or greater when the input signal VIN is 0 V. A potential difference between the potential (a) and a potential (b) at the gate of the third FET, i.e., at the drain of the second first-conduction-type transistor is secured for an entire range (from 0V to VDD) of voltage changes that may occur in the input signal VIN. More precisely, the invention provides a differential circuit of an operational amplifier comprising a differential amplifier circuit portion (1) involving differentially connected first and second first-conduction-type FETs (T11, T12) for differentially amplifying an input voltage, a current mirror circuit portion (2) involving first and second second-conduction-type FETs (T13, T14) connected to the differential amplifier circuit portion (1) on the side of a first power source (VDD), a constant-current circuit portion (3) connected to the differential amplifier circuit portion (1) on the side of a second power source (GND), and an output circuit portion (4) involving a third second-conduction-type FET (T7) having a gate terminal connected to the drain terminal of the second first-conduction-type FET (T12), and a constant-current circuit. The first and second first-conduction-type FETs (T11, T12) are of depletion type having a threshold value equal to or smaller than the level of the second power source (GND). Back gates of the first and second first-conduction-type FETs (T11, T12) are maintained at a predetermined potential.

According to the invention, a potential (a) at the node between the differential amplifier circuit portion and the constant-current circuit portion (3) is set to 0 V or greater when the input signal VIN is 0 V. A potential difference between the potential (a) and a potential (b) at the gate of the third FET is secured for an entire range (from 0 V to VDD) of changes that occur in the voltage of the input signal VIN. Even if the input signal is 0 V, the transistors (T11, T12) of the differential amplifier circuit portion surely operate, and the output voltage VOUT completely responds to the input voltage VIN, which may vary within the range of 0 V to VDD.

## BRIEF DESCRIPTION OF THE DRAWINGS

Fig. 1 is an electric circuit diagram showing an embodiment of the invention;

Fig. 2 is an explanatory view showing an operation of the embodiment;

Fig. 3 is an electric circuit diagram showing a prior art;

Fig. 4 is an explanatory view showing an operation of the prior art;

Fig. 5 is a view showing examples of the sizes of transistors of a differential amplifier according to the invention;

Fig. 6 is an input-output characteristic diagram showing a differential amplifier circuit of the prior art of Fig. 3;

Fig. 7 is an input-output characteristic diagram showing the differential amplifier circuit of the prior art of Fig. 3 with back gates of enhancement-type transistors being connected to GND;

Fig. 8 is an input-output characteristic diagram showing the differential amplifier circuit of the prior art of fig. 3 with the enhancement-type transistors being replaced with depletion-type transistors having back gates connected to a source;

Fig. 9 is an input-output characteristic diagram showing the arrangement of Fig. 8 with the back gates of the depletion-type transistors being connected to GND;

Fig. 10 is an input-output characteristic diagram showing the arrangement of Fig. 8 with the back gates of the depletion-type transistors being connected to a power source of -5 V according to the invention; and

Fig. 11 is a view showing an example of a digital tuning electronic variable resistor employing an operational amplifier involving a differential amplifier according to the invention.

## BEST MODE OF CARRYING OUT THE INVENTION

A differential amplifier of an operational amplifier according to the invention will be explained in detail with reference to the drawings.

The differential amplifier according to the invention used for an operational amplifier has the previously explained basic configuration. The conventional differential amplifier explained with reference to Fig. 4 does not activate the transistors thereof when the input signal voltage is in a range of from 0 V to 1.0 V. Also, when the input signal VIN approaches VDD, which may be 2.5 V or 5 V, the difference between the source terminal potential (a) and the drain terminal potential (b) of the transistors of the differential amplifier is zeroed, so that the output voltage VOUT does not follow changes in the input voltage VIN. To solve these problems, the differential amplifier according to the invention employs depletion-type FETs as first and second FETs (T11, T12), and fixes back gates of the depletion FETs to a power source having a potential of less than 1 V, preferably 0 V, more preferably a negative value. This arrangement enables the transistors of the differential amplifier to continuously operate even if the input voltage VIN is nearly zeroed, thereby solving the problems of the prior art. Since the invention fixes the back gates of the depletion-type FETs to 0 V or lower, the source terminal potential (a) of the differential amplifier gently changes, so that the potential difference between the two nodes (a) and (b) is sufficiently reserved even if the input voltage VIN approaches VDD.

In this way, the output voltage VOUT of the operational amplifier of the invention completely follows the input voltage VIN for an entire range of changes that occur in the input voltage VIN.

The invention secures a potential difference between the two nodes (a) and (b) by setting the sizes, such as threshold values of the FETs (T13, T14) of the current mirror circuit, to be smaller than those of the FETs of the differential amplifier. This may reduce a voltage drop at the node (b) to enlarge the potential difference between the two nodes.

The threshold voltage of the depletion-type FETs of the invention is set to 0 V or smaller, so that they may operate even if the input voltage VIN is 0 V.

On the other hand, the threshold value of the enhancement-type FETs is set to about 1 V, so that they may not operate if the input voltage VIN is 0 V.

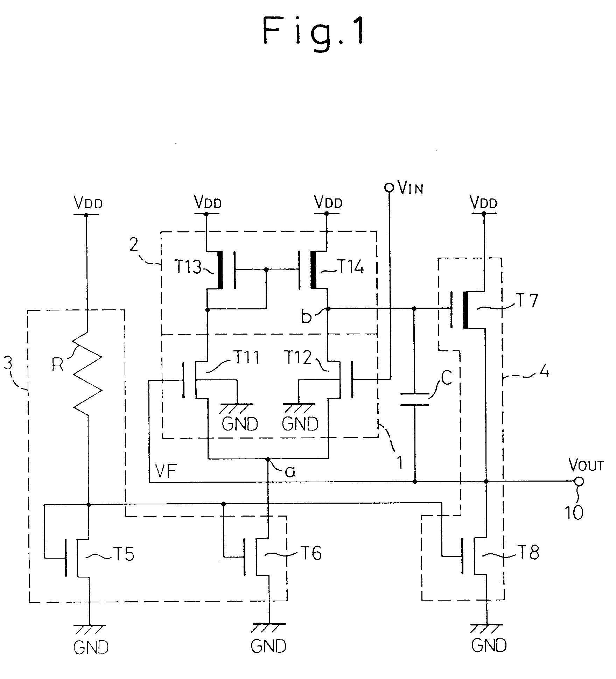

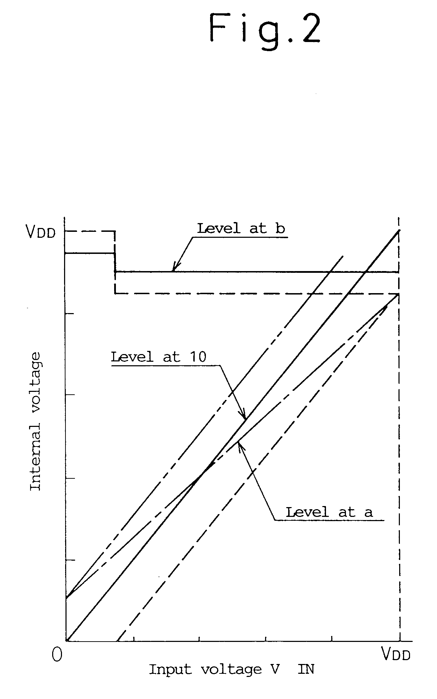

A differential amplifier according to an embodiment of the invention serving as a voltage follower type output buffer of an operational amplifier will be explained with reference to Figs. 1 and 2.

For the sake of simplicity, the parts as shown in Fig. 3 are represented with similar reference marks, and their explanations will not be repeated.

Figure 1 is an electric circuit diagram showing the embodiment of the invention. A differential amplifier circuit portion 1 comprises first and second depletion-type NMOS transistors T11 and T12 having a threshold value of 0 V or lower. Back gates of the first and second NMOS transistors T11 and T12 are connected to a predetermined power source, for example, a ground GND.

A current mirror circuit portion 2 comprises first and second PMOS transistors T13 and T14 having a smaller threshold value than the transistors T11 and T12 of the differential amplifier circuit portion.

When an input voltage VIN is in a range of 0 V to VDD, the first and second NMOS transistors T11 and T12 are always active. As a result, the potential level of a node (a) indicated with a dash-and-dot line in Fig. 2 is always larger than 0 V, and gently rises in proportion to the input voltage VIN. Namely, the depletion-type first and second NMOS transistors T11 and T12 of the invention provide an effect of changing a dotted line representing the prior art employing enhancement-type transistors to the dash-and-dot line. Since the back gates of the first and second NMOS transistors T11 and T12 are connected to the ground GND, a substrate bias is increased to make the dash-and-dot line gentler.

Since the first and second NMOS transistors T11 and T12 are always active, the first and second PMOS transistors T13 and T14 are always ON to activate a third PMOS transistor T7 of an output circuit portion 4. Even if the input voltage VIN approaches the level of the high voltage source VDD, a potential difference for activating the first and second PMOS transistors T13 and T14 is secured between a source voltage of the first and second NMOS transistors T11 and T12 and the high voltage source VDD, to activate the third PMOS transistor T7.

As shown in Fig. 2, an output voltage VOUT, i.e., the level of an output terminal 10 is normal relative to the input voltage VIN even if the input voltage VIN approaches 0 V. The output voltage is also normal relative to the input voltage VIN even if the input voltage VIN approaches the level of the high voltage source VDD. In this way, a linearity of the output voltage VOUT is guaranteed from the level of the high voltage source VDD to the level of the ground GND.

According to the embodiment, the threshold value of the first and second PMOS transistors T13 and T14 of the current mirror circuit portion 2 is lower than that of the transistors T11 and T12 of the differential amplifier circuit. Because of this, the potential level of the node (b) is changed from the dotted line (indicating the potential level of the prior art of Fig. 4) to the continuous line in Fig. 2. Even if the input voltage VIN is close to the level of the high voltage source VDD, the first and second PMOS transistors T13 and T14 can surely be activated to guarantee a linearity of output voltage VOUT on the high voltage source VDD side.

In this embodiment, the ground GND is a low voltage source. This low voltage source may be a proper negative voltage source, or -VDD.

This embodiment relates to the voltage follower type output buffer. This does not limit the invention.

When the back gates of the depletion-type FETs are connected to a low voltage source other than GND according to the invention, this low voltage source is preferably a separate power source.

As will be explained later, the level of the low voltage source to which the back gates of the depletion-type transistors are connected is preferably about -0.5 V.

The FETs employed by the invention may have any configuration, and the most preferable and practical configuration is MOS.

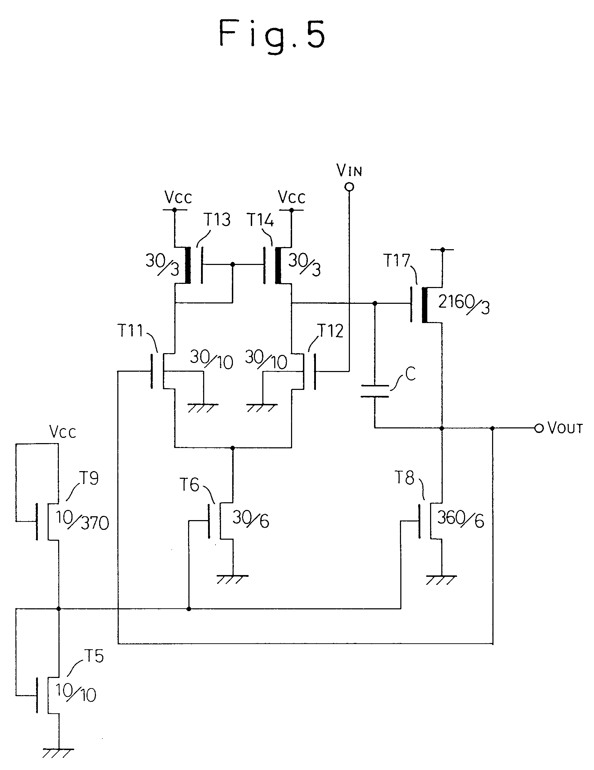

Figure 5 shows examples of the sizes, i.e., W/L ratios of MOS transistors employed by the invention. In this figure, the resistor R of the constant current circuit portion 3 is replaced with a MOS transistor T9. As is apparent in Fig. 5, the sizes of the transistors T13 and T14 of the current mirror circuit are smaller than those of the MOS transistors T11 and T12 of the differential amplifier circuit, to set a lower threshold value.

According to the invention, the first and second first-conduction-type MOS transistors (T11, T12) of the differential amplifier circuit portion 1 are depletion type transistors having a threshold value lower than the level of the second power source (GND), so that the first and second first-conduction-type MOS transistors are always active. Accordingly, the first and second second-conduction-type MOS transistors of the current mirror circuit portion 2 are active to turn ON the third second-conduction-type MOS transistor (T7) of the output circuit portion 4. The back gates of the first and second first-conduction-type MOS transistors (T11, T12) are connected to the predetermined low potential source, so that the rate of rise of the source voltage of the first and second first-conduction-type MOS transistors is smaller than the rate of rise of the input voltage. Accordingly, even if the input voltage is close to the level of the first power source (VDD), a potential difference for activating the first and second second-conduction-type MOS transistors of the current mirror circuit portion is obtained between the source voltage of the first and second first-conduction-type MOS transistors and the first power source. As a result, the third second-conduction-type MOS transistor can be activated.

The operational amplifier circuit according to the invention may be used for a voltage follower type output buffer in which the gate terminal of the first first-conduction-type MOS transistor of the differential amplifier circuit portion receives an output voltage, and the gate terminal of the second first-conduction-type MOS transistor thereof receives an input voltage. In this case, even if the input voltage is close to the level of the second power source, the output voltage will be normal relative to the input voltage. Also, even if the input voltage is close to the level of the first power source, the output voltage is normal relative to the input voltage. A linearity of output voltage is thus guaranteed from the level of the first power source to the level of the second power source.

The threshold value of the first and second second-conduction-type MOS transistors of the current mirror circuit portion is small. When the operational amplifier circuit is used as the voltage follower type output buffer, the input voltage surely activates the first and second second-conduction-type MOS transistors even if the input voltage is close to the level of the first power source. This ensures a linearity of output voltage on the first power source side.

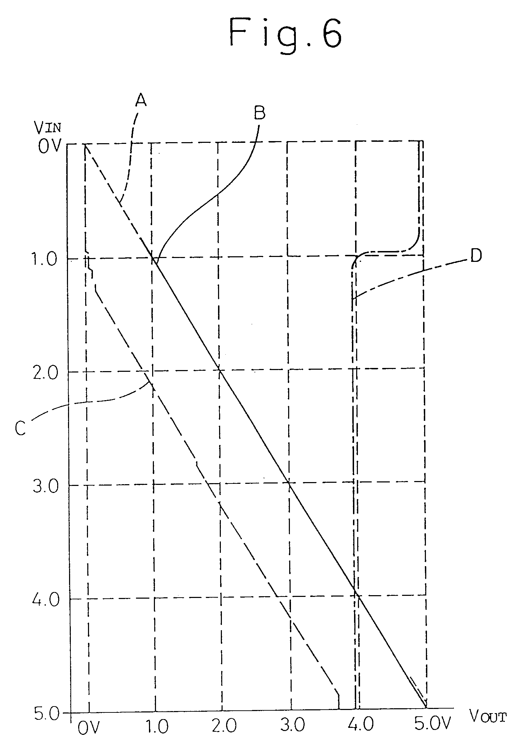

Differences in characteristics of operational amplifiers employing the differential amplifier circuit of the invention and that of the conventional differential amplifier circuit will be explained with reference to Figs. 6 through 10.

Figure 6 shows input-output characteristics of an operational amplifier employing the conventional differential amplifier circuit of Fig. 3. In Fig. 6, an ordinate represents the output voltage VOUT (changing from 0 to 5.0 V), and an abscissa represents the input voltage VIN (changing from 0 to 5.0 V).

Figure 6 corresponds to Fig. 4.

In Fig. 6, a graph B indicated with a continuous line shows a voltage at the output VOUT 10 of Fig. 3, and a graph A indicated with a dotted line shows a voltage at the input VIN of the same figure.

A dotted line C indicates a voltage at the node (a) of Fig. 3, i.e., at the source of the transistor T12 of the differential amplifier 1. A dash-and-dot line D shows changes in the drain voltage of the transistor T12.

When the output voltage VOUT completely follows the input voltage VIN, the graph of the output voltage VOUT is visible. In this case, the graph of the input voltage VIN is behind the graph of the output voltage VOUT, and therefore, invisible.

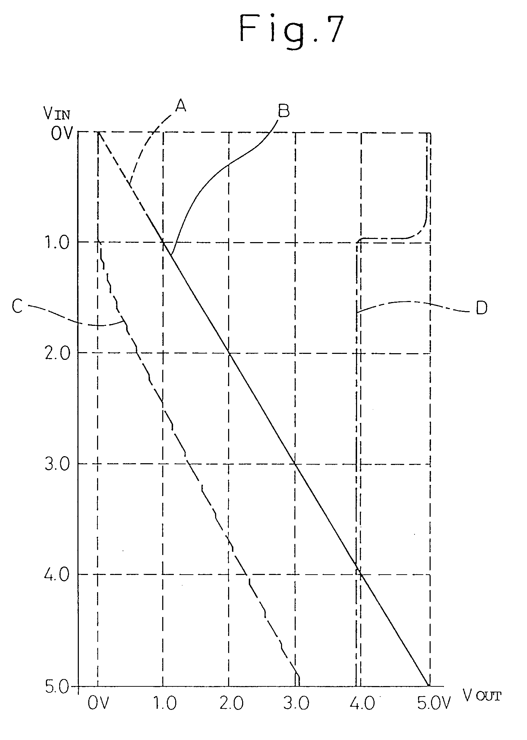

When they do not agree with each other, one of the graphs appear, or both appear in parallel. (This is true for all graphs following Fig. 7.)

In Fig. 6, the input signal voltage VIN changes from 0 V to 5 V, and according to the changes, the output voltage VOUT and the voltage at the nodes change as plotted in the figure.

When the input signal voltage VIN decreases below 1.0 V, i.e., below the threshold value of the transistor T12, the output voltage disappears, and instead, only the graph of the input voltage VIN appears.

In this way, the conventional operational amplifier stops providing the output voltage VOUT if the input voltage decreases below 1.0 V, i.e., the threshold value of the transistor T12.

According to this prior art, the graph of the node (a) and that of the node (b) approach each other to reduce a potential difference between them below a sufficient level as the input voltage VIN approaches the level of VDD. In this case, the output voltage VOUT does not follow changes in the input voltage VIN.

Figure 7 shows input-output characteristics of the conventional differential amplifier circuit of Fig. 3 with back gates of the enhancement-type transistors being connected to GND.

Since the back gates of the enhancement-type transistors are connected to GND, a potential at the node (a) changes gentler than in the example of Fig. 6. Accordingly, even if the input voltage VIN approaches the level of VDD, the graph of the node (a) and that of the node (b) are separated from each other. This means that there is a sufficient potential difference between them, so that the output voltage VOUT can sufficiently follow changes in the input voltage VIN.

When the input voltage VIN decreases below 1.0 V, however, the output characteristics deteriorate.

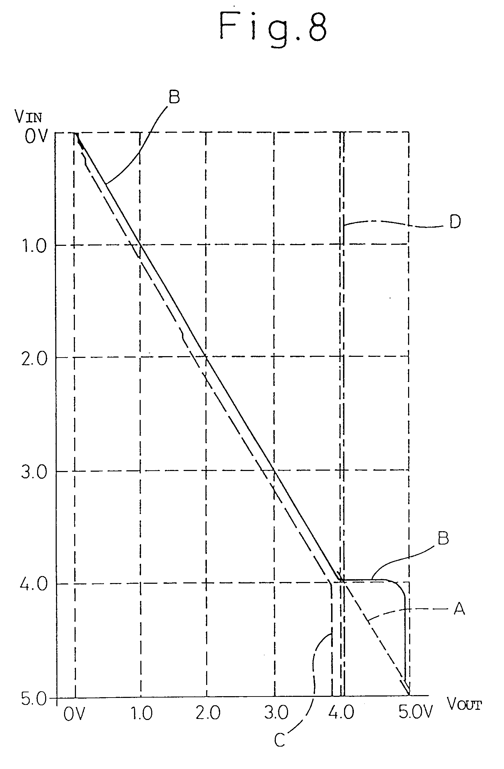

Figure 8 shows input-output characteristics of the conventional differential amplifier circuit of Fig. 3 using depletion-type transistors instead of enhancement-type transistors, with back gates of the transistors being connected to their sources.

According to this example, a graph of the node (a) shows that the node can hold a potential of 0 V or over even if the input voltage VIN falls below 1.0 V. Namely, the graph of the output voltage VOUT is completely visible even when the input voltage VIN falls below 1.0 V, to show that the output characteristics of the node (a) surely follow those of the input voltage VIN.

The output voltage VOUT of this example, however, abruptly jumps to about 5 V when the input voltage VIN increases to 4 to 5 V. As a result, only the graph of the input voltage VIN is continuously visible.

This means that, when the input voltage VIN exceeds 4 V, the output voltage VOUT of this circuit can no longer follow the input voltage VIN.

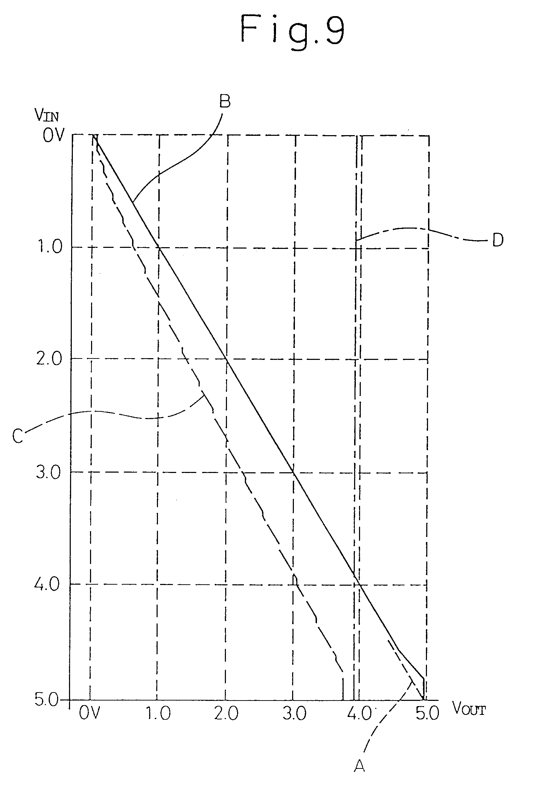

Figure 9 shows input-output characteristics of an example of the invention employing depletion-type transistors whose back gates are connected to GND.

According to this example, the node (a) holds a potential of 0 V or larger even when the input voltage VIN is smaller than 1.0 V, and therefore, the graph of the output voltage VOUT is completely visible even if the input voltage VIN decreases below 1.0 V. Namely, the output voltage VOUT surely follows the input voltage VIN even if the input voltage VIN falls below 1.0 V.

Since the back gates are connected to GND in this example, a potential at the node (a) gently changes, so that, even if the input voltage VIN approaches the level of VDD, the graph of the node (a) is separated from that of the node (b). Namely, there is a sufficient potential difference between them, so that the output voltage VOUT can sufficiently follow changes in the input voltage VIN.

Only when the input voltage VIN comes very close to the level of VDD, the same problem as that of Fig. 6 occurs. This, however, is not critical.

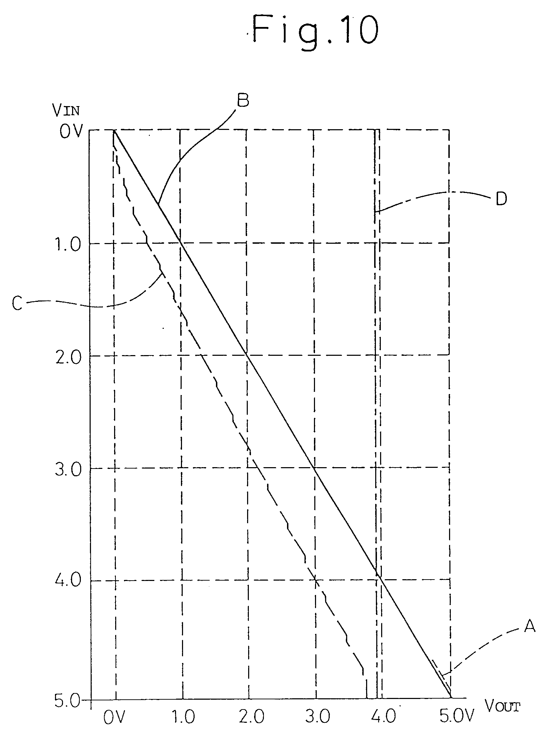

Figure 10 shows input-output characteristics of another example according to the invention with the same arrangement as the example of Fig. 8 but with back gates of depletion-type transistors being connected to a power source of -0.5 V.

According to this example, a potential at the node (a) changes in response to the input signal VIN more gently than in Fig. 9. As a result, a potential difference between the nodes (a) and (b) is more surely secured for a whole range of changes in the input voltage VIN.

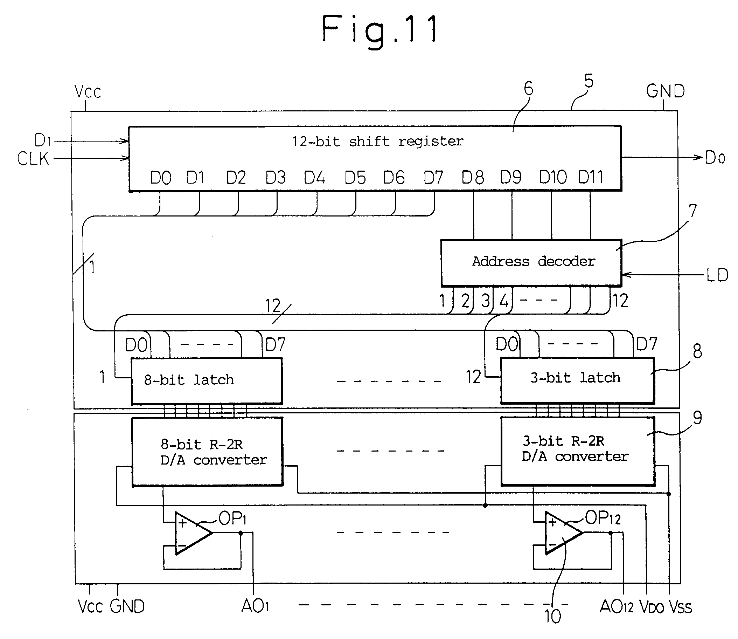

The operational amplifier employing the differential amplifier circuit according to the invention is applicable for various fields. As an example, Fig. 11 shows a digital tuning electronic variable resistor employing the operational amplifier.

The digital tuning electronic variable resistor 5 comprises a 12-bit shift register 6, an address decoder 7, 8-bit latches 8, and 8-bit D/A converters 9. The operational amplifier is disposed between each D/A converter 9 and each output AO.

EFFECT OF THE INVENTION

As explained above in detail, the invention provides an excellent effect of guaranteeing linearity of output voltage relative to input voltage ranging from the level of a first power source to that of a second power source.

The first and second second-conduction-type MOS transistors of the current mirror circuit portion have a small threshold value, so that these transistors may be activated even if the input voltage is close to the level of the first power source, to surely guarantee a linearity of output voltage on the first power source side.

**Claims**

1. A differential amplifier circuit of an operational amplifier comprising a differential amplifier circuit portion (1) involving differentially connected first and second first-conduction-type FETs (T11, T12) for differentially amplifying an input voltage, a current mirror circuit portion (2) involving first and second second-conduction-type FETs (T13, T14) connected to the differential amplifier circuit portion (1) on the side of a first power source (VDD), a constant-current circuit portion (3) connected to the differential amplifier circuit portion (1) on the side of a second power source (GND), and an output circuit portion (4) involving a third second-conduction-type FET (T7) having a gate terminal connected to a drain terminal of the second first-conduction-type FET (T12), and a constant-current circuit, wherein a potential difference between a potential (a) at a node between the differential amplifier circuit portion and the constant-current circuit portion (3) and a potential (b) at a gate of the third FET is secured for an entire range (0 V to VDD) of changes in the input voltage (VIN).

2. A differential amplifier circuit of an operational amplifier, comprising a differential amplifier circuit portion (1) involving differentially connected first and second first-conduction-type FETs (T11, T12) for differentially amplifying an input voltage, a current mirror circuit portion (2) involving first and second second-conduction-type FETs (T13, T14) connected to the differential amplifier circuit portion (1) on the side of a first power source (VDD), a constant-current circuit portion (3) connected to the differential amplifier circuit portion (1) on the side of a second power source (GND), and an output circuit portion (4) involving a third second-conduction-type FET (T7) having a gate terminal connected to a drain terminal of the second first-conduction-type FET (T12), and a constant-current circuit, wherein the first and second first-conduction-type FETs (T11, T12) are depletion type transistors having a threshold value equal to or smaller than the level of the second power source (GND), and back gates of the first and second first-conduction-type FETs (T11, T12) are maintained at a predetermined potential.

3. A differential amplifier circuit of an operational amplifier circuit according to claim 2, wherein a threshold value of the first and second second-conduction-type FETs (T13, T14) is smaller than that of the first and second first-conduction-type FETs (T11, T12).

4. A differential amplifier circuit of an operational amplifier circuit according to claim 2, wherein the predetermined potential is equal to a ground voltage (0 V) or smaller.

# Fig.1

# Fig.2

# Fig.3

# Fig.4

EP 0 499 645 A1

# Fig.5

13

# Fig.6

# Fig.7

# Fig.8

# Fig.9

# Fig.10

# Fig.11

EP 0 499 645 A1

# INTERNATIONAL SEARCH REPORT

**I. CLASSIFICATION OF SUBJECT MATTER (if several classification symbols apply, indicate all)** [6]

According to International Patent Classification (IPC) or to both National Classification and IPC

Int. Cl$^5$  H03F3/45

**II. FIELDS SEARCHED**

| Minimum Documentation Searched [7] | |
|---|---|
| Classification System | Classification Symbols |
| IPC | H03F3/45 |

| Documentation Searched other than Minimum Documentation to the Extent that such Documents are Included in the Fields Searched [8] |
|---|
| Jitsuyo Shinan Koho          1926 – 1991 |
| Kokai Jitsuyo Shinan Koho    1971 – 1991 |

**III. DOCUMENTS CONSIDERED TO BE RELEVANT** [9]

| Category [*] | Citation of Document, [11] with indication, where appropriate, of the relevant passages [12] | Relevant to Claim No. [13] |
|---|---|---|
| P | JP, U, 3-48924 (Shin Nippon Musen K.K.), May 13, 1991 (13. 05. 91), (Family: none) | 1 |
| Y | JP, A, 1-264406 (Texas Instruments Inc.), October 20, 1989 (20. 10. 89), Fig. 2 & US, A, 4887048 | 1, 2, 4 |
| Y | JP, A, 55-92008 (Fujitsu Ltd.), July 12, 1980 (12. 07. 80), Lines 5 to 7, column 5 (Family: none) | 1, 2, 4 |
| Y | JP, A, 56-93406 (Suwa Seikosha K.K.), July 29, 1981 (29. 07. 81), Line 18, column 4 to line 1, column 5 (Family: none) | 1, 2, 4 |
| A | JP, A, 61-186009 (NEC Corp.), August 19, 1986 (19. 08. 86), (Family: none) | 1 |

\* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| December 10, 1991 (10. 12. 91) | December 17, 1991 (17. 12. 91) |
| International Searching Authority | Signature of Authorized Officer |
| Japanese Patent Office | |

Form PCT/ISA/210 (second sheet) (January 1985)